# EUROPÄISCHE PATENTSCHRIFT

(11) **EP 3 602 788 B1**
(45) Veröffentlichungstag und Bekanntmachung des Hinweises auf die Patenterteilung: **10.05.2023**
(21) Anmeldenummer: 18713879.7
(22) Anmeldetag: 23.03.2018
(51) Int. Cl.: E05B 81/76, H03K 17/96

(54) **SENSORANORDNUNG**
SENSOR ARRANGEMENT
ENSEMBLE DE CAPTEURS

(30) Priorität: 30.03.2017 DE 102017106869; 22.03.2018 DE 102018106771
(43) Veröffentlichungstag der Anmeldung: 05.02.2020
(73) Patentinhaber: Huf Hülsbeck & Fürst GmbH & Co. KG, 42551 Velbert (DE)
(72) Erfinder: SIEG, Berthold, 46240 Bottrop (DE); STAHL, Daniel, 31515 Wunstorf (DE)
(74) Vertreter: Bals & Vogel Patentanwälte PartGmbB
(86) Internationale Anmeldenummer: PCT/EP2018/057543
(87) Internationale Veröffentlichungsnummer: WO 2018/177963

(56) Entgegenhaltungen:
- EP-A1- 3 016 286
- WO-A1-00/54131
- GB-A- 2 409 842
- US-A1- 2009 167 699
- US-A1- 2013 162 594
- US-A1- 2016 224 086
- US-A1- 2016 365 620

## Beschreibung

Die vorliegende Erfindung betrifft eine Sensoranordnung für ein Fahrzeug. Ferner bezieht sich die Erfindung auf ein Verfahren zum Betreiben einer Sensoranordnung. Sensoranordnungen mit integrierten kapazitiven Sensoren sind allgemein bekannt, insbesondere deren Anwendung in Türaußengriffen von Kraftfahrzeugen. So ist beispielsweise in der DE 196 17 038 A1 ein Türgriff mit kapazitiven Sensoren offenbart, welche die Detektion einer Annäherung eines potentiellen Bedieners ermöglichen.

US 2009/167699 A1, US 2016/365620 A1 und US 2016/224086 A1 offenbaren einen kapazitiven Berührungssensor mit einer Spule, die einen Berührungsbereich umgibt.

Herkömmliche kapazitive Annäherungssensoren umfassen eine Sensorelektrode und eine Ansteuer- und/oder Auswerteschaltung. Die Ansteuer- und/oder Auswerteschaltung misst dabei die Kapazität der Elektrode gegenüber Masse. Durch Annäherung einer Hand des Bedieners wird die Kapazität der Elektrode verändert, und die Kapazitätsänderung kann durch die Ansteuer- und/oder Auswerteschaltung erfasst werden.

Ferner ist bekannt, dass Benutzer von Kraftfahrzeugen im Alltag möglichst wenig durch mitgeführte Geräte und Schlüssel für Kraftfahrzeuge belastet werden möchten. Daher besteht der Wunsch, Funktionen des Kraftfahrzeuges auch durch die Verwendung von Geräten mit anderer Hauptfunktion zu legitimieren, die vom Benutzer mitgeführt werden. Dies können beispielsweise Mobiltelefone oder Smartphones sein. Zum Informationsaustausch zwischen einem Mobilgerät und dem Fahrzeug können dabei Nahfeld-Übertragungsvorrichtungen als Kommunikationsschnittstelle eingesetzt werden. Insbesondere sind dazu Kommunikationsschnittstellen gemäß dem NFC-Standard etabliert und in zahlreichen Mobilgeräten bereits eingebaut.

Der Bauraum innerhalb eines Bedienelements am Fahrzeugs, z. B. innerhalb eines Türgriffs, ist begrenzt. Sowohl ein kapazitiver Sensor als auch eine Nahfeld-Übertragungsvorrichtung können umso sensitiver ausgebildet werden, je mehr Platz für deren sensitive Elemente (also die Sensor-Elektrode und die Nahfeld-Übertragungsspule) zur Verfügung steht. Gleichzeitig ist häufig ein Problem, dass Störeinflüsse auf den kapazitiven Sensor bzw. die Nahfeld-Übertragungsvorrichtung reduziert werden müssen. Dabei können sich die elektronischen Komponenten des Fahrzeuges gegebenenfalls auch untereinander störend beeinflussen.

Es ist daher eine Aufgabe der vorliegenden Erfindung, die voranstehend beschriebenen Nachteile zumindest teilweise zu beheben. Insbesondere ist es Aufgabe der vorliegenden Erfindung, bei einer Sensoranordnung den Betrieb des kapazitiven Sensors und/oder der Nahfeld-Übertragungsvorrichtung zu verbessern. Vorzugsweise soll der Platzaufwand für den kapazitiven Sensor und/oder die Nahfeld-Übertragungsvorrichtung reduziert werden und/oder es sollen Störeinflüsse verringert werden.

Die voranstehende Aufgabe wird gelöst durch eine Sensoranordnung mit den Merkmalen des unabhängigen Vorrichtungsanspruchs und durch ein Verfahren mit den Merkmalen des unabhängigen Verfahrensanspruchs. Weitere Merkmale und Details der Erfindung ergeben sich aus den jeweiligen Unteransprüchen, der Beschreibung und den Zeichnungen. Dabei gelten Merkmale und Details, die im Zusammenhang mit der erfindungsgemäßen Sensoranordnung beschrieben sind, selbstverständlich auch im Zusammenhang mit dem erfindungsgemäßen Verfahren, und jeweils umgekehrt, so dass bezüglich der Offenbarung zu den einzelnen Erfindungsaspekten stets wechselseitig Bezug genommen wird bzw. werden kann.

Die Aufgabe wird insbesondere gelöst durch eine Sensoranordnung, insbesondere Sensoreinrichtung, für ein Fahrzeug, wobei die Sensoranordnung wenigstens eine der nachfolgenden Elektronikkomponenten aufweist:
- wenigstens eine kapazitive Sensorvorrichtung, insbesondere ein kapazitiver Sensor, wobei vorzugsweise die kapazitive Sensorvorrichtung wenigstens eine Sensorelektrode zur kapazitiven Erfassung aufweist,
- wenigstens eine Nahfeld-Übertragungsvorrichtung, insbesondere eine Nahfeld-Übertragungseinrichtung, vorzugsweise eine NFC-Schnittstelle, wobei bevorzugt die Nahfeld-Übertragungsvorrichtung wenigstens eine Nahfeld-Übertragungsspule mit zumindest einer (insbesondere elektrisch leitenden) Windung benachbart zur Sensorelektrode zur kontaktlosen (insbesondere Nahfeld-) Übertragung aufweist,
- wenigstens eine Steuerelektronik, welche ausgebildet ist, die Nahfeld-Übertragungsspule kooperativ zur Sensorelektrode anzusteuern, um die kapazitive Erfassung zu unterstützen.

In anderen Worten hat die Nahfeld-Übertragungsspule wenigstens zwei Funktionen: sie ist dazu ausgeführt, die kontaktlose Übertragung durchzuführen und die kapazitive Erfassung zu unterstützen. Dies hat den Vorteil, dass die Sensitivität und damit der Betrieb der kapazitiven Sensorvorrichtung verbessert wird. Beide Funktionen können durch dieselbe Nahfeld-Übertragungsspule und insbesondere auch dieselbe Windung platzsparend bereitgestellt werden. Die kontaktlose Übertragung kann dabei eine Primärfunktion der Nahfeld-Übertragungsspule sein, und die Unterstützung der kapazitiven Erfassung eine Sekundärfunktion der Nahfeld-Übertragungsspule sein. Es kann vorgesehen sein, dass die Nahfeld-Übertragungsspule nur genau eine dieser Funktionen gleichzeitig bereitstellen kann. Somit kann die Bereitstellung der Primärfunktion und die Bereitstellung der Sekundärfunktion in einem Ausschließlichkeitsverhältnis zueinanderstehen.

Erfindungsgemäß wird die Nahfeld-Übertragungsspule kooperativ zur Sensorelektrode durch die Steuerelektronik angesteuert. Damit ist insbesondere gemeint, dass die Nahfeld-Übertragungsspule die kapazitive Erfassung der Sensorelektrode aktiv unterstützt - also kooperativ zur Sensorelektrode wirkt. In anderen Worten bewirkt die kooperative Ansteuerung eine weitergehende kapazitive Erfassung, als dies bspw. nur durch die Nutzung der Sensorelektrode möglich wäre. Diese kooperative Ansteuerung, insbesondere als aktive Ansteuerung der Nahfeld-Übertragungsspule, bewirkt daher ggf. eine verbesserte kapazitive Erfassung, als dies bei Nutzung einer Nahfeld-Übertragungsspule der Fall ist, welche außerhalb des Einflussbereichs auf die Sensorelektrode angeordnet ist. Entsprechend kann die wenigstens eine Windung sich innerhalb eines Einflussbereichs auf die Sensorelektrode befinden, um die kapazitive Erfassung zu unterstützen.

Optional kann es möglich sein, dass die kapazitive Sensorvorrichtung als kapazitiver Annäherungssensor ausgebildet ist. Bspw. ist die wenigstens eine kapazitive Sensorvorrichtung hierzu in einem Türgriff und/oder in einem Türschweller und/oder in einem Stoßfänger und/oder im Front- und/oder Seiten- und/oder Heckbereich des Fahrzeuges angeordnet. Es kann möglich sein, dass die kapazitive Sensorvorrichtung in diesen Bereichen jeweils wenigstens eine Sensorelektrode aufweist, um eine Annäherung in diesen Bereichen zu erfassen. Bspw. kann eine Erfassung der Annäherung im Heckbereich dazu führen, dass eine Heckklappe geöffnet wird. Ferner kann die Erfassung der Annäherung im Seitenbereich dazu führen, dass eine Authentifizierung mit einem Identifikationsgeber initiiert wird und/oder das Fahrzeug entriegelt wird und/oder sich eine Seitentür des Fahrzeuges öffnet. Die Erfassung der Annäherung im Frontbereich ermöglicht hingegen bspw. das Öffnen der Motorhaube. Somit ist ein vielseitiger und komfortabler Einsatz der Sensorvorrichtung möglich. Für jeden der Bereiche kann es dabei vorgesehen sein, dass die kapazitive Erfassung für einen vorgegebenen Wunschbereich vorgesehen ist. Bspw. ist dabei die jeweilige (wenigstens eine) Sensorelektrode auf diesen Wunschbereich ausgerichtet, um dort die gewünschte (z. B. maximale) Sensitivität aufzuweisen.

Die Nahfeld-Übertragungsvorrichtung ist bspw. als eine NFC-Schnittstelle (NFC steht hierbei für engl. Near Field Communication - also Nahfeldkommunikation), d. h. gemäß einem NFC-Standard, ausgeführt. Dabei kann mittels elektromagnetischer Induktion über lose gekoppelte Spulen die kontaktlose Übertragung, d. h. insbesondere eine Datenübertragung, bereitgestellt werden. Eine dieser Spulen kann als die Nahfeld-Übertragungsspule über die wenigstens eine Windung gebildet sein. Die weitere Spule kann an einem Identifikationsgeber, einem mobilen Gerät oder dergleichen ausgebildet sein, um die kontaktlose Übertragung zwischen der weiteren Spule und der Nahfeld-Übertragungsspule durchzuführen (z. B. zum Austausch einer Authentifizierungsinformation).

Das Fahrzeug ist vorzugsweise als ein Kraftfahrzeug und/oder als ein Personenkraftfahrzeug und/oder als ein Elektrofahrzeug und/oder als ein Hybridfahrzeug und/oder als ein autonomes (selbstfahrendes) Fahrzeug ausgebildet. Bevorzugt weist das Fahrzeug ein passives Zugangssystem, vorzugweise ein Keyless-Entry-System, und/oder ein Keyless-Go-System auf. In anderen Worten kann bei dem Fahrzeug optional vorgesehen sein, dass eine Annäherung eines Identifikationsgebers detektiert wird, und bei erfolgreicher Detektion der Annäherung ein Signal (z. B. Wecksignal) ausgesandt wird. Das Signal initiiert damit automatisch die Authentifizierung des Identifikationsgebers am Fahrzeug, ohne dass eine manuelle Betätigung des Identifikationsgebers erforderlich ist.

Der Identifikationsgeber ist z. B. als elektronischer Schlüssel oder als Smartphone oder als Mobilfunkvorrichtung, vorzugsweise jeweils als Nahfeld-Mobilvorrichtung, ausgeführt. Wenn der Identifikationsgeber als Nahfeld-Mobilvorrichtung, vorzugsweise NFC-Mobilvorrichtung ausgeführt ist, weist dieser eine Nahfeld- bzw. NFC-Schnittstelle zur kontaktlosen (drahtlosen) Kommunikation mit der Nahfeld-Übertragungsvorrichtung auf. Nach Empfang des Wecksignals kann der Identifikationsgeber z. B. eine Authentifizierungsinformation, z. B. einen Code, automatisch an das Fahrzeug übertragen, um z. B. anhand der Authentifizierungsinformation ein Entriegeln des Fahrzeuges zu bewirken. Dies kann bspw., ggf. auch zusätzlich, durch eine Nahfeldübertragung durchgeführt werden, also durch die kontaktlose Übertragung von der Nahfeld-Mobilvorrichtung an die Nahfeld-Übertragungsvorrichtung.

Es kann vorgesehen sein, dass die erfindungsgemäße Sensoranordnung derart ausgebildet ist, dass die Sensorelektrode in einem von der Windung der Nahfeld-Übertragungsspule umgriffenen Innenbereich ausgebildet ist. Alternativ oder zusätzlich kann es möglich sein, dass die Nahfeld-Übertragungsspule und/oder die Sensorelektrode als Leiterbahnen und/oder Leiterflächen auf einer Leiterplatte ausgebildet sind. Die Nahfeld-Übertragungsspule und/oder die Sensorelektrode können dabei auf derselben Ebene der Leiterplatte ausgebildet sein, oder - bei einer mehrschichtigen Leiterplatte - auf verschiedenen Ebenen der Leiterplatte ausgebildet sein. Dabei kann durch die Nahfeld-Übertragungsspule ein Innenbereich definiert sein, welcher innerhalb der Windung liegt, jedoch nicht von der Windung bedeckt ist. In anderen Worten handelt es sich dabei um einen windungsfreien Innenbereich, wobei gegebenenfalls in der Windungsachse verlaufende Projektionen des Innenbereichs über die Schichten oder Ebenen der Leiterplatte vorgesehen sind. Vorzugsweise ist die Sensorelektrode in diesem freien Innenbereich der Nahfeld-Übertragungsspule ausgebildet.

Ferner kann es im Rahmen der Erfindung möglich sein, dass die Sensorelektrode mit einer besonderen Geometrie ausgebildet ist, um die Wirbelströme in der Sensorelektrode zu minimieren. Beispielsweise kann es im Betrieb der Nahfeld-Übertragungsvorrichtung in der Sensorelektrode im freien Innenbereich zur Induktion von Wirbelströmen kommen. Diese Wirbelströme bringen ein Magnetfeld hervor, welches dem erzeugenden Magnetfeld entgegenwirkt und damit die Kommunikationsfähigkeit der Nahfeld-Übertragungsvorrichtung erheblich einschränkt. Erfindungsgemäß kann die Sensorelektrode mit einem langgestreckten Mittelleiter ausgebildet und/oder mit einer Mehrzahl von Abzweigleitern ausgebildet sein, wobei sich die Abzweigleiter von dem Mittelleiter aus erstrecken können. Hierbei können die Abzweigleiter entlang des Mittelleiters beabstandet voneinander angeordnet sein, so dass die Abzweigleiter gleichsam wie Zweige von dem Mittelleiter abstehen und nur über den Mittelleiter galvanisch miteinander gekoppelt sind. Optional können die Abzweigleiter auf ihrer dem Mittelleiter abgewandten Seite freie (nicht elektrisch mit weiteren Bauteilen gekoppelte) Enden aufweisen. Darüber hinaus können die Abzweigleiter jeweils paarweise zu voneinander abgewandten Seiten an dem Mittelleiter angeordnet sein, so dass zu jedem Abzweigleiter ein zugeordneter Abzweigleiter auf der jeweils abgewandten Seite des Mittelleiters ausgebildet ist. Dabei ist es möglich, dass sämtliche Leiter, Mittelleiter und/oder Abzweigleiter als Leiterbahnen auf einer Ebene der Leiterplatte ausgebildet sind.

Ferner ist es optional bei der erfindungsgemäßen Sensoranordnung möglich, dass der Mittelleiter zusammen mit den Abzweigleitern die Sensorelektrode bildet, und gegebenenfalls eine Art von Tannenzweig-Struktur und/oder zweiseitiger Kammstruktur bildet. Auch kann es möglich sein, dass die Abzweigleiter eine beliebige Form einnehmen, und vorzugsweise die Abzweigleiter miteinander und/oder mit dem Mittelleiter keine geschlossene Ringstruktur bilden, in denen sich größere Wirbelstrombereiche ausbilden können.

Von weiterem Vorteil ist es, wenn die Sensorelektrode ein Detektionsgebiet teilweise mit Leiterstrukturen belegt, gegebenenfalls ohne Raum für die Ausbildung größerer Wirbelstrombereiche zu bieten. Es hat sich hierbei gezeigt, dass auf diese Weise sowohl eine verlässliche Detektion des kapazitiven Sensors möglich ist, als auch ein sensitiver Betrieb der Nahfeld-Übertragungsspule. Da ein und derselbe Flächenbereich der Leiterplatte sowohl für die kapazitive Sensorelektrode als auch für die Nahfeld-Übertragungsvorrichtung, insbesondere die Nahfeld-Übertragungsspule genutzt werden kann, ist eine kompaktere Bauform der Sensoranordnung möglich, oder aber eine weitere Erstreckung des sensitiven Bereichs sowohl der Nahfeld-Übertragungsvorrichtung als auch der kapazitiven Sensorvorrichtung.

In einer vorteilhaften Weiterbildung der Erfindung sind alle Paare von Abzweigleitern jeweils zueinander symmetrisch ausgebildet. Dies bedeutet, dass bezogen auf den Ansatzpunkt der Abzweigleiter am Mittelleiter jedes Paar von Abzweigleitern symmetrisch hinsichtlich seiner Länge, Breite und seiner Formgebung sein kann. Auf diese Weise können ungewollt induzierte Spannungen in den leitenden Elektrodenflächen des kapazitiven Sensors während des Betriebs der Nahfeld-Übertragungsvorrichtung reduziert werden.

In einer Weiterbildung der Erfindung sind die Abzweigleiter sämtlich gerade gestreckt ausgebildet und in einem einheitlichen Abzweigwinkel zu dem Mittelleiter angeordnet. Die einheitliche gerade Ausbildung der Abzweigleiter und der einheitliche Abzweigwinkel können dabei zu einem einheitlichen Abstand der Mittelleiter zueinander führen. Entsprechend können induktive und kapazitive Effekte zwischen den Mittelleitern gegebenenfalls einheitlich über deren Länge mit geringst möglicher Schwankung anzutreffen sein.

Es kann vorteilhaft sein, wenn die Nahfeld-Übertragungsspule mit einem rechteckigen Spulenquerschnitt auf einer Leiterplatte ausgebildet ist, und vorzugsweise dabei der Mittelleiter der Sensorelektrode entlang einer Symmetrieachse des Spulenquerschnitts ausgebildet ist. Wird entsprechend die Nahfeld-Übertragungsspule gemäß einem rechteckigen Flächeninhalt um einen Bereich der Leiterplatte geführt, so kann entlang der Mittelachse dieses Rechtecks der Mittelleiter der Sensorelektrode ausgebildet werden, wobei sich vorzugsweise dann zu zwei Seiten dieses Mittelleiters die Abzweigleiter erstrecken. Die Anordnung in dieser Position kann vorteilhaft sein, weil eine symmetrische Mittelachse das Induktionsspannungsminimum bildet und so in der Sensorelektrode ungewollte induzierte Spannungen möglichst klein gehalten werden.

Es ist in einer Weiterbildung der Erfindung möglich, dass eine Mehrschichtplatine zur Ausbildung der Sensoranordnung vorgesehen ist, wobei vorzugsweise die Sensorelektrode auf einer Lage der Mehrschichtplatine angeordnet ist und/oder auf wenigstens einer weiteren Ebene der Mehrschichtplatine, insbesondere darunter, zu der Sensorelektrode eine deckungsgleiche Elektrode als Schirmelektrode (auch Shield-Elektrode) oder auch als Bezugselektrode ausgebildet ist.

Ferner kann es möglich sein, dass die Elektroden deckungsgleich, d. h. mit gleicher Geometrie und senkrecht zur Leiterplattenebene deckungsgleich, ausgerichtet sind.

Vorteilhaft ist es zudem, wenn die Steuerelektronik ausgebildet ist, für die kooperative Ansteuerung die Nahfeld-Übertragungsspule dann auf ein von einem Massepotential abweichendes Potential zu legen, wenn die kapazitive Sensorvorrichtung in einem Erfassungszustand zur kapazitiven Erfassung aktiviert ist. Beispielsweise ist das von dem Massepotential abweichende Potential ein Potential im Bereich von 1 Volt bis 10 Volt, vorzugsweise 2,5 Volt bis 5 Volt. Vorzugsweise ist die Steuerelektronik dadurch dazu ausgebildet, für die kooperative Ansteuerung die Nahfeld-Übertragungsspule auf dieses Potential zu legen, in dem die Steuerelektronik wenigstens einen elektronischen Schalter, ein Schaltmittel oder dergleichen ansteuert. Auf diese Weise kann von einer Übertragungsverschaltung zu einer Erfassungsverschaltung gewechselt werden, da die Steuerelektronik hierzu wenigstens einen Schaltkreis der Sensoranordnung modifiziert. Dies hat den Vorteil, dass die Nahfeld-Übertragungsspule im Erfassungszustand dieses (von einem Massepotential abweichende) Potential aufweist, um aktiv die kapazitive Erfassung zu unterstützen.

Die Steuerelektronik ist z. B. als ein Mikrocontroller oder als Teil eines Mikrocontrollers oder eines integrierten Schaltkreises oder dergleichen ausgebildet. Vorzugsweise ist die Steuerelektronik auf derselben Leiterplatte befestigt, wie die Nahfeld-Übertragungsspule und/oder die Sensorelektrode, und optional elektrisch mit diesen über wenigstens eine Leiterbahn verbunden. Zur Anlegung eines Potentials an die Nahfeld-Übertragungsspule, d. h. zur Ansteuerung der Nahfeld-Übertragungsspule, kann die Steuerelektronik optional mit wenigstens einem Schaltmittel, z. B. einem elektronischen Schalter, verbunden sein. Dieses Schaltmittel kann die Nahfeld-Übertragungsspule elektrisch mit einer Spannungsquelle verbinden.

Erfindungsgemäß ist die Steuerelektronik ausgebildet, für die kooperative Ansteuerung ein Potential der Nahfeld-Übertragungsspule in Abhängigkeit von einem Potential der Sensorelektrode festzulegen, vorzugsweise sodass ein Verhältnis zwischen dem Potential der Nahfeld-Übertragungsspule und dem Potential der Sensorelektrode minimiert wird, um eine kapazitive Last bei der kapazitiven Erfassung zu verringern. In anderen Worten ist die Steuerelektronik ausgebildet, für die kooperative Ansteuerung die Nahfeld-Übertragungsspule auf ein Potential anzulegen, welches von einem Potential abhängig ist, das an der Sensorelektrode anliegt. Auf diese Weise kann ein derartiges Potential für die Nahfeld-Übertragungsspule im Erfassungszustand gewählt werden, welches die kapazitive Erfassung der Sensorelektrode unterstützt. Dies ist beispielsweise ein solches Potential, welches dem Potential der Sensorelektrode möglichst nahe kommt.

Es ist ferner denkbar, dass die Steuerelektronik ausgebildet ist, für die kooperative Ansteuerung die Nahfeld-Übertragungsspule auf ein Potential anzulegen, welches einem Potential zumindest im Wesentlichen entspricht, das an der Sensorelektrode anliegt. Dies hat den Vorteil, dass ein elektrisches Feld im Einflussbereich für die Sensorelektrode möglichst homogen gehalten wird, um die Signifikanz der Erfassung der Sensorelektrode für einen gewünschten Wirkbereich zu erhöhen. In anderen Worten kann die Sensitivität der Sensorelektrode für diesen gewünschten Wirkbereich durch den Einsatz der Nahfeld-Übertragungsspule verbessert werden.

Es kann optional möglich sein, dass die Steuerelektronik ausgebildet ist, die Nahfeld-Übertragungsspule dann kooperativ zur Sensorelektrode anzusteuern, wenn die kapazitive Sensorvorrichtung in einem Erfassungszustand zur kapazitiven Erfassung aktiviert ist, und andernfalls zumindest in einen Übertragungszustand zur kontaktlosen Übertragung umschaltet, sodass bevorzugt abwechselnd die kapazitive Erfassung und die kontaktlose Übertragung erfolgt, vorzugsweise jedoch niemals gleichzeitig. Insbesondere bezieht sich dabei die kooperative Ansteuerung auf eine Ansteuerung, bei welcher die Nahfeld-Übertragungsspule und die Sensorelektrode einem gemeinsamen Zweck dienen, nämlich insbesondere der kapazitiven Erfassung. Aufgrund der räumlichen Nähe der Nahfeld-Übertragungsspule im Einflussbereich zur Sensorelektrode kann jedoch die kapazitive Erfassung nicht gleichzeitig mit der kontaktlosen Übertragung erfolgen, da in diesem Falle die Nahfeld-Übertragungsspule die kapazitive Erfassung und/oder umgekehrt, stören würde. Die abwechselnde Nutzung dieser beiden Funktionen hat also den Vorteil, dass eine platzsparende Ausbildung der Sensoranordnung möglich ist.

Ferner kann es im Rahmen der Erfindung vorgesehen sein, dass die Steuerelektronik ausgebildet ist, für die kooperative Ansteuerung einen ersten der Anschlüsse der Nahfeld-Übertragungsspule mit einem einzigen Anschlusspunkt einer Spannungsquelle, vorzugsweise Betriebsspannungsquelle, der Sensoranordnung elektrisch zu verbinden. In anderen Worten kann dieser erste Anschluss mit einem einzigen Potential verbunden werden, welches von der Spannungsquelle bereitgestellt wird. Vorzugsweise kann hierdurch der erste Anschluss auf ein Betriebspotential gelegt werden. Bevorzugt kann hierbei die Betriebsspannungsquelle zur Bereitstellung von 2,5 V oder 5 V als Betriebspotential ausgeführt sein. Des Weiteren kann ein zweiter der Anschlüsse der Nahfeld-Übertragungsspule geöffnet werden. Alternativ kann auch der zweite Anschluss auf dasselbe Potential der Spannungsquelle, bspw. auf das Betriebspotential der Betriebsspannungsquelle, gelegt werden. Auf diese Weise kann zuverlässig und sicher die kapazitive Erfassung unterstützt werden.

In einer weiteren Möglichkeit kann vorgesehen sein, dass die Steuerelektronik ausgebildet ist, für die kooperative Ansteuerung die Nahfeld-Übertragungsspule in eine Erfassungsverschaltung der Nahfeld-Übertragungsspule zu überführen, sodass vorzugsweise ein Störeinfluss der Nahfeld-Übertragungsspule auf die kapazitive Erfassung der Sensorelektrode reduziert wird. Dieser Störeinfluss wird beispielsweise erzeugt, wenn die Nahfeld-Übertragungsspule das elektrische Feld der Sensorelektrode in ungewünschter Weise richtet und/oder beeinflusst, z. B. durch ein bestimmtes Potential (gegebenenfalls auch Massepotential), welches an der Nahfeld-Übertragungsspule anliegt. In anderen Worten kann ein derartiges Potential für die Nahfeld-Übertragungsspule gewählt werden, welches den Störeinfluss reduziert.

Es kann von Vorteil sein, wenn im Rahmen der Erfindung die Steuerelektronik ausgebildet ist, für die kooperative Ansteuerung die Nahfeld-Übertragungsspule in eine Erfassungsverschaltung der Nahfeld-Übertragungsspule zu überführen, sodass die Nahfeld-Übertragungsspule in einem Randbereich angrenzend zu einem Wirkbereich der Sensorelektrode ein elektrisches Feld erzeugt, welches vorzugsweise an ein von der Sensorelektrode erzeugtes elektrisches Feld in dem Wirkbereich angeglichen ist, um bevorzugt so die kapazitive Erfassung zu unterstützen. Der Wirkbereich ist dabei beispielsweise ein gewünschter Bereich, in welchem eine Annäherung durch die kapazitive Sensorvorrichtung detektiert werden soll. In anderen Worten soll im Wirkbereich möglichst die Erfassung durch die Sensorelektrode erfolgen. Dagegen kann der Randbereich ein Bereich sein, in welchem die Annäherung nicht zu erfasst werden braucht. Somit kann der Randbereich zur Begrenzung des Wirkbereichs dienen und somit zur Begrenzung der kapazitiven Erfassung dienen. Auf diese Weise kann sehr zuverlässig der sensitive Bereich für die kapazitive Erfassung angepasst werden.

Gemäß einem weiteren Vorteil kann vorgesehen sein, dass eine Erfassungsverschaltung der Nahfeld-Übertragungsspule zur Unterstützung der kapazitiven Erfassung sich von einer Übertragungsverschaltung der Nahfeld-Übertragungsspule zur kontaktlosen Übertragung unterscheidet. Dies ist beispielsweise dadurch möglich, dass wenigstens ein Schaltmittel im Erfassungszustand einen anderen Schaltzustand aufweist als im Übertragungszustand. Damit kann sehr zuverlässig das Potential beeinflusst werden, welches an der Nahfeld-Übertragungsspule anliegt.

Ferner ist es bei der erfindungsgemäßen Sensoranordnung möglich, dass die Steuerelektronik ausgebildet ist, abwechselnd zwischen einer Erfassungsverschaltung der Nahfeld-Übertragungsspule in einem Erfassungszustand zur kapazitiven Erfassung und einer Übertragungsverschaltung der Nahfeld-Übertragungsspule in einem Übertragungszustand zur kontaktlosen Übertragung umzuschalten. Dies erfolgt bspw. durch ein Umschalten wenigstens eines Schaltmittels. Damit wird sowohl eine kontaktlose Übertragung als auch eine kapazitive Erfassung durch dieselbe Sensoranordnung möglich. Diese kann dann sehr platzsparend z. B. in einen Türgriff integriert werden.

Es kann ferner möglich sein, dass die Nahfeld-Übertragungsspule in einem Erfassungszustand zur kapazitiven Erfassung über eine Erfassungsverschaltung mit einer Gleichspannungsquelle verbunden ist. Dies ermöglicht es, ein konstantes Potential zur Unterstützung der kapazitiven Erfassung an die Nahfeld-Übertragungsspule zu legen.

Vorteilhaft ist es zudem, wenn die Nahfeld-Übertragungsspule in einem Erfassungszustand zur kapazitiven Erfassung über eine Erfassungsverschaltung mit einer programmierbaren Quelle verbunden ist, um programmierbar ein Potential für die Nahfeld-Übertragungsspule festzulegen. Dies ermöglicht eine sehr flexible Anpassung des Potentials, z. B. an das durch die Sensorelektrode genutzte Potential.

Optional kann es vorgesehen sein, dass die Nahfeld-Übertragungsspule in einem Übertragungszustand zur kontaktlosen, vorzugsweise induktiven, Übertragung über eine Übertragungsverschaltung mit einer Kontrollelektronik zur Durchführung der kontaktlosen Übertragung verbunden ist, wobei vorzugsweise die Steuerelektronik dazu ausgeführt ist, diese Verbindung mit der Kontrollelektronik in einem Erfassungszustand zumindest teilweise aufzuheben, um eine Erfassungsverschaltung bereitzustellen. Dieses Aufheben der Verbindung kann beispielsweise durch das Umschalten wenigstens eines Schaltmittels erfolgen. Die Kontrollelektronik ist dabei beispielsweise eine für eine NFC-Übertragung angepasste Elektronik, z. B. ein integrierter Schaltkreis oder dergleichen. Auf diese Weise kann z. B. eine Datenübertragung für eine Authentifizierung beim Fahrzeug bereitgestellt werden.

Gemäß einer vorteilhaften Weiterbildung der Erfindung kann vorgesehen sein, dass die wenigstens eine Windung, insbesondere schleifenförmig, die Sensorelektrode umgibt, um die kapazitive Erfassung zu unterstützen, vorzugsweise um ein von der Sensorelektrode erzeugtes elektrisches Feld im Erfassungszustand zu unterstützen und/oder abzuschirmen und/oder zu richten. In anderen Worten kann die Nahfeld-Übertragungsspule im Erfassungszustand ggfs. zur Ausrichtung des elektrischen Feldes dienen, welches durch die kapazitive Sensorvorrichtung bzw. durch die Sensorelektrode erzeugt wird. Dagegen kann die Nahfeld-Übertragungsspule im Übertragungszustand zur Bereitstellung und/oder Beeinflussung und/oder Erfassung eines magnetischen Feldes dienen, insbesondere als NFC-Antenne. Diese Mehrfachfunktionalität hat den Vorteil, dass eine platzsparende Sensoranordnung bereitgestellt werden kann. Zudem können die Funktionen gegebenenfalls sehr kostengünstig für das Fahrzeug bereitgestellt werden.

Ferner ist es optional vorgesehen, dass die Nahfeld-Übertragungsspule und die Sensorelektrode derart zueinander auf einer Leiterplatte angeordnet sind, dass die Sensorelektrode in einem von der Windung umgriffenen Innenbereich ausgebildet ist. Insbesondere kann ein äußerer Punkt der Sensorelektrode max. 1 mm oder max. 5 mm oder max. 10 mm oder max. 1 cm oder max. 2 cm oder max. 5 cm von der Nahfeld-Übertragungsspule, insbesondere der Windung, beabstandet angeordnet sein. Auf diese Weise kann eine sehr platzsparende Sensoranordnung bereitgestellt werden.

Weiter kann es bei der Erfindung vorgesehen sein, dass die Steuerelektronik ausgebildet ist, die Sensorelektrode dann auf ein Massepotenzial zu legen, wenn die Nahfeld-Übertragungsspule in einem Übertragungszustand zur kontaktlosen Übertragung aktiviert ist. Hierdurch kann der Vorteil erzielt werden, dass auch die Sensorelektrode im Übertragungszustand nicht die kontaktlose Übertragung negativ beeinflusst.

Außerdem kann es im Rahmen der Erfindung von Vorteil sein, dass die Nahfeld-Übertragungsspule als PCB-Antenne (PCB steht hierbei für engl. printed circuit board) zur Nahfeldkommunikation ausgeführt ist. In anderen Worten kann es sich um eine gedruckte Antenne handeln, welche somit sehr platzsparend ausgeführt sein kann.

Vorzugsweise kann vorgesehen sein, dass eine wenigstens einschichtige Leiterplatte vorgesehen ist, auf welcher die wenigstens eine Sensorelektrode und/oder die wenigstens eine Windung ausgebildet sind. Dies ermöglicht einen einfachen kostengünstigen Aufbau der Sensoranordnung.

Ferner ist es denkbar, dass die Sensorelektrode einen langgestreckten Mittelleiter aufweist und eine Mehrzahl von Abzweigleitern, die sich von dem Mittelleiter erstrecken, wobei vorzugsweise die Abzweigleiter sich entlang des Mittelleiters derart beabstandet voneinander erstrecken, dass die Abzweigleiter ausschließlich über den Mittelleiter galvanisch gekoppelt sind, wobei bevorzugt die Abzweigleiter jeweils paarweise zu voneinander abgewandten Seiten an dem Mittelleiter angeordnet sind, so dass zu jedem Abzweigleiter ein zugeordneter Abzweigleiter auf der jeweils abgewandten Seite des Mittelleiters ausgebildet ist. Es kann ferner möglich sein, dass jedes Paar von Abzweigleitern bezüglich des Mittelleiters symmetrisch ausgebildet ist. Zudem ist es denkbar, dass sämtliche Abzweigleiter gerade ausgebildet sind und in einem einheitlichen Abzweigwinkel zu dem Mittelleiter abzweigen. Dies ermöglicht eine verbesserte Bauraumnutzung mit optimierter Sensitivität der Sensorelektrode, bei welcher gegebenenfalls auch Wirbelstromverluste reduziert werden können.

Ebenfalls Gegenstand der Erfindung ist ein Verfahren zum Betreiben einer Sensoranordnung eines Fahrzeuges, vorzugsweise einer erfindungsgemäßen Sensoranordnung.

Vorteilhafterweise kann bei einem erfindungsgemäßen Verfahren zumindest einer der nachfolgenden Schritte durchgeführt werden, wobei die Schritte bevorzugt nacheinander in der angegebenen Reihenfolge oder in beliebiger Reihenfolge durchgeführt werden, und ggf. auch einzelne Schritte wiederholt werden können:
- Ansteuern einer Nahfeld-Übertragungsspule zur kontaktlosen Übertragung, wenn sich die Sensoranordnung in einem Übertragungszustand befindet,
- Ansteuern der Nahfeld-Übertragungsspule zur Unterstützung einer kapazitiven Erfassung einer Sensorelektrode, wenn sich die Sensoranordnung in einem Erfassungszustand befindet,
- Umschalten zwischen dem Erfassungszustand und dem Übertragungszustand.

Damit bringt das erfindungsgemäße Verfahren die gleichen Vorteile mit sich, wie sie ausführlich mit Bezug auf eine erfindungsgemäße Sensoranordnung beschrieben worden sind. Zudem kann es vorgesehen sein, dass eine erfindungsgemäße Sensoranordnung zur Durchführung der Schritte eines erfindungsgemäßen Verfahrens ausgeführt ist.

Es ist ferner denkbar, dass die kontaktlose Übertragung zur Datenübertragung von Authentifizierungsinformationen von einem Identifikationsgeber an das Fahrzeug durchgeführt wird, um eine sicherheitsrelevante Funktion (z. B. Entriegelung) am Fahrzeug zu aktivieren, und vorzugsweise die kapazitive Erfassung zur Detektion einer Annäherung an das Fahrzeug durchgeführt wird, um bevorzugt bei erfolgreicher Detektion die kontaktlose Übertragung zu aktivieren, besonders bevorzugt durch das Umschalten von dem Erfassungszustand auf den Übertragungszustand. Dies ermöglicht eine schnelle, zuverlässige und komfortable Aktivierung von Fahrzeugfunktionen durch die Sensoranordnung.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
In den nachfolgenden Figuren werden für die gleichen technischen Merkmale auch von unterschiedlichen Ausführungsbeispielen die identischen Bezugszeichen verwendet.
- Figur 1: eine schematische Darstellung eines Fahrzeugtürgriffs mit einer erfindungsgemäßen Sensoranordnung,
- Figur 2: eine schematische Darstellung einer erfindungsgemäßen Sensoranordnung,
- Figur 3: eine schematische Darstellung einer erfindungsgemäßen Sensoranordnung
- Figur 4 - 6: schematische Darstellungen einer Magnetfeldverteilung bei jeweiligen Sensoranordnungen,
- Figur 7 - 9: schematische Darstellungen eines Aufbaus erfindungsgemäßer Sensoranordnungen,
- Figur 10 - 11: schematische Darstellungen eines elektrischen Feldes bei Sensoranordnungen.

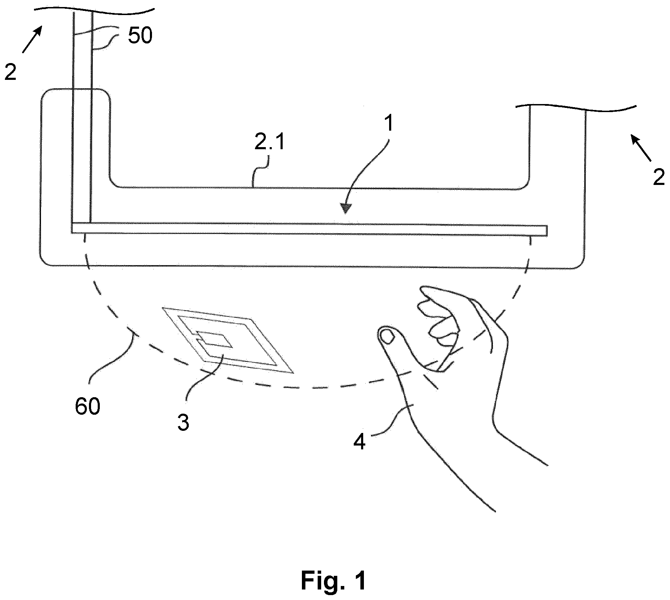

Figur 1 ist ein Fahrzeugtürgriff 2.1. eines Fahrzeuges 2 gezeigt. In dem Fahrzeugtürgriff 2.1. ist eine erfindungsgemäße Sensoranordnung 1 angeordnet. Von der Sensoranordnung 1 führen gegebenenfalls Zuleitungen 50 zu einer fahrzeugseitigen zentralen Steuereinrichtung, insbesondere einer zentralen Fahrzeugelektronik. Ferner kann die erfindungsgemäße Sensoranordnung 1 ein Detektionsfeld 60 ausbilden. Ein (gewünschter) Wirkbereich 27 einer kapazitiven Sensorvorrichtung 10 erstreckt sich dabei zumindest teilweise innerhalb dieses Detektionsbereichs 60. In diesem Wirkbereich 27 kann die Annäherung eines Aktivierungsmittels 4, insbesondere einer Hand eines Bedieners, erfasst werden. Ferner ist zumindest ein Teil des Detektionsfelds 60 auch ein Übertragungsbereich, in welchem eine kontaktlose Übertragung zu einer Nahfeld-Übertragungsvorrichtung 20 erfolgen kann. Hierzu wird beispielsweise eine NFC-Mobilvorrichtung 3 in den Übertragungsbereich gebracht, um eine elektromagnetische, insbesondere induktive Wechselwirkung mit der Nahfeld-Übertragungsvorrichtung 20 zu ermöglichen.

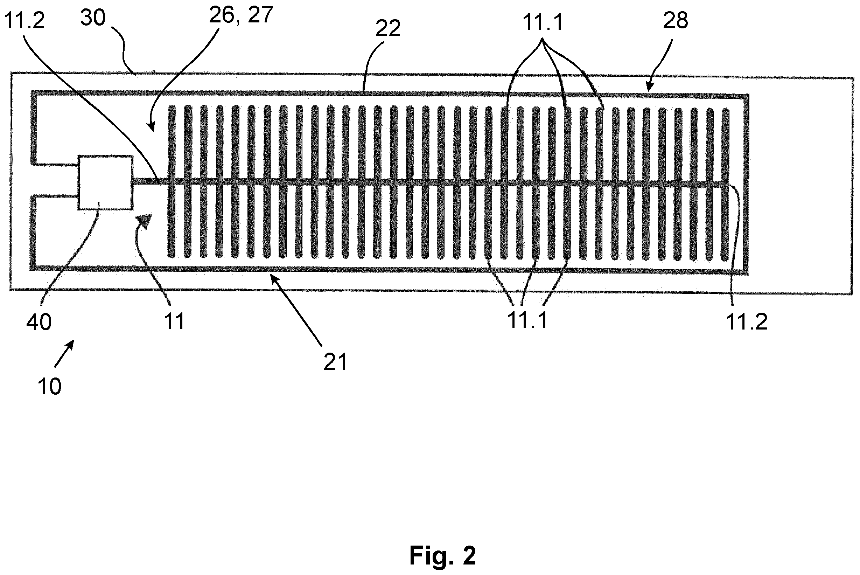

In Figur 2 ist die erfindungsgemäße Sensoranordnung 1 gemäß einem ersten Ausführungsbeispiel dargestellt. Eine Leiterplatte 30 ist hierbei als einschichtige Leiterplatte 30 ausgebildet. Im Randbereich 28 der Leiterplatte 30 läuft eine Windung 22 einer Nahfeld-Übertragungsspule 21 um. Die Windung 22 ist mit einer Steuerelektronik 40 gekoppelt, mit der zusammen sie eine Nahfeld-Übertragungsvorrichtung 20 bildet. Ebenfalls mit der Steuerelektronik 40 gekoppelt ist eine Sensorelektrode 11. Diese weist einen Mittelleiter 11.2 und eine Vielzahl an Abzweigleitern 11.1 auf. Die Abzweigleiter 11.1 sind nur teilweise mit Bezugszeichen versehen, um die Abbildung nicht unübersichtlich zu gestalten. Die Abzweigleiter 11.1 bilden zusammen mit dem Mittelleiter 11.2 die Sensorelektrode 11, die sich innerhalb des von der Nahfeld-Übertragungsspule 21 umgriffenen Bereichs der Leiterplatte 30 befindet. Der Mittelleiter 11.2 ist entlang der Symmetrieachse der Nahfeld-Übertragungsspule 21 ausgebildet.

Zwischen den Abzweigleitern 11.1 sind unbelegte, leiterfreie Zwischenräume ausgebildet, so dass die Abzweigleiter 11.1 nur über den Mittelleiter 11.2 galvanisch gekoppelt sind. Die Abzweigleiter 11.1 weisen in dieser Ausführungsform sämtlich dieselbe Länge auf und erstrecken sich spiegelsymmetrisch von dem Mittelleiter 11.2 zur Ausbildung einer doppelten Kammstruktur. Die Abstände der Abzweigleiter 11.1 sind in dieser Darstellung sämtlich einheitlich, ebenso wie die Länge. Außerdem sind die Abzweigleiter 11.1 gerade ausgebildet.

Die Sensorelektrode 11 kann zur Detektion im zeitlichen Wechsel mit der Nahfeld-Übertragungsvorrichtung 20 und der zugehörigen Nahfeld-Übertragungsspule 21 aktiviert werden. Durch die grätenartige Struktur der Sensorelektrode 11 ist es möglich, das durch die Nahfeld-Übertragungsspule 21 aufgebaute Magnetfeld zur Kopplung mit einem NFC-fähigen Gerät ohne größere Störungen aufzubauen.

Darüber hinaus ist in Figur 2 schematisch gezeigt, dass sich die Windung 22 im Wesentlichen in einem Randbereich 28 erstreckt, welcher sich angrenzend zu einem Wirkbereich 27 erstreckt. In dem gezeigten Ausführungsbeispiel entspricht dabei der Wirkbereich 27 einem Innenbereich 26, welcher durch die Windung 22 umfasst wird. Auf diese Weise kann ein klar definierter Wirkbereich 27 für die kapazitive Erfassung einer Annäherung definiert werden.

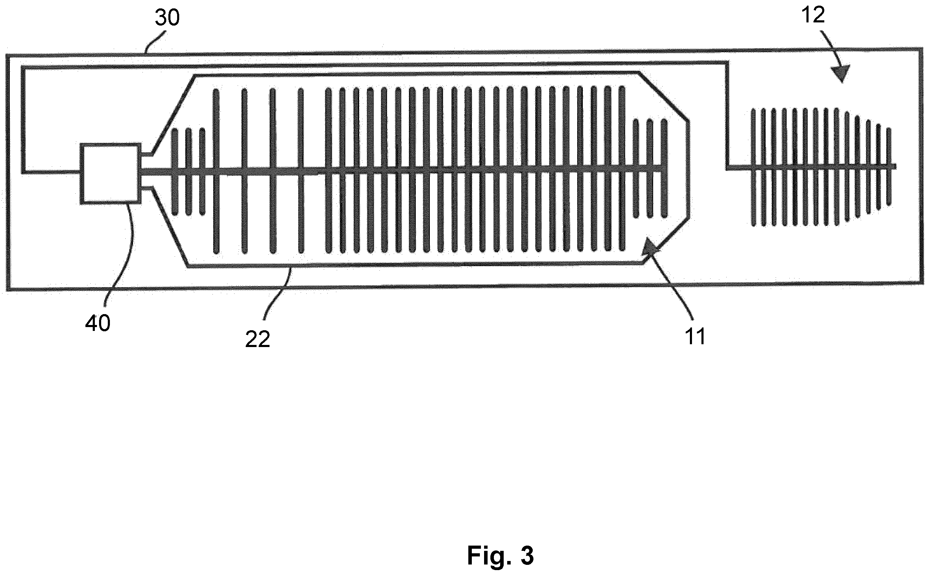

Figur 3 zeigt eine erfindungsgemäße Sensoranordnung 1 gemäß einem weiteren Ausführungsbeispiel. In dieser Ausführung ist eine Leiterplatte 30 vorgesehen, die eine Steuerelektronik 40 aufweist. Eine Windung 22 ist als Leiterbahn auf der Leiterplatte 30 zur Bildung einer Nahfeld-Übertragungsspule 21 ausgebildet. Innerhalb des inneren freien Bereichs der Nahfeld-Übertragungsspule 21 ist eine Sensorelektrode 11 ausgebildet. Aus dieser Darstellung ist ersichtlich, dass die Sensorelektrode 11 einen Mittelleiter 11.2 mit unterschiedlich langen Abzweigleitern 11.1 aufweist. Außerdem sind die Abzweigleiterpaare mit unterschiedlichen Abständen entlang des Mittelleiters 11.2 angeordnet. Der Mittelleiter 11.2 ist entlang der Symmetrieachse der Nahfeld-Übertragungsspule 21 ausgebildet. Weiterhin ist die Steuerelektronik 40 mit einer zweiten Sensorelektrode 12 verbunden, die außerhalb der Nahfeld-Übertragungsspule 21 liegt. Auch diese weist eine symmetrische Struktur mit einer Vielzahl von Abzweigleitern 11.1 auf, die beabstandet voneinander angeordnet sind. Hierbei wird deutlich, dass die erfindungsgemäße Sensoranordnung 1 mit unterschiedlichen Abständen zwischen den Abzweigleitern 11.1 realisiert werden kann und auch mit unterschiedlichen Längen der Abzweigleiter 11.1. Die Abzweigleiter 11.1 sind jedoch paarweise symmetrisch an dem Mittelleiter 11.2 angeordnet.

Die erfindungsgemäße Sensoranordnung 1 kann in der Praxis dazu dienen, beispielsweise im Türgriff, einen Bereich für eine Türöffnung, detektiert durch die Sensorelektrode 11, von einem Bereich für die Türschließung, detektiert durch die Sensorelektrode 12, abzugrenzen. Ferner kann es gegebenenfalls vorgesehen sein, dass auch um die Sensorelektrode 12 eine weitere Nahfeld-Übertragungsspule ausgebildet ist.

Es ist denkbar, dass die Sensoranordnung 1 mit unterschiedlichen Teilungsverhältnissen gebildet sein kann. Dabei kann es anwendungsabhängig sein, welche Breite die Abzweigleiter 11.1 und der Mittelleiter 11.2 aufweisen. Beispielsweise betragen die Breiten der Abzweigleiter 11.1 0,3 mm bis 2,0 mm. Auch die Abstände können z. B. 0,3 mm bis 2 mm betragen. Die Breiten der Abzweigleiter 11.1 können gegebenenfalls auch deutlich größer gewählt werden, z. B. bis 3 oder 5 mm, und die Abstände können gegebenenfalls kleiner sein. Auch die Anzahl der Abzweigleiter 11.1 kann gegebenenfalls variiert werden. Beispielsweise kann wenigstens eine Anzahl von 5 Abzweigleiterpaaren an einem Mittelleiter 11.2 vorgesehen sein, wobei erheblich mehr Abzweigleiterpaare, z. B. 20 bis 100 Abzweigleiterpaare, vorgesehen sein können.

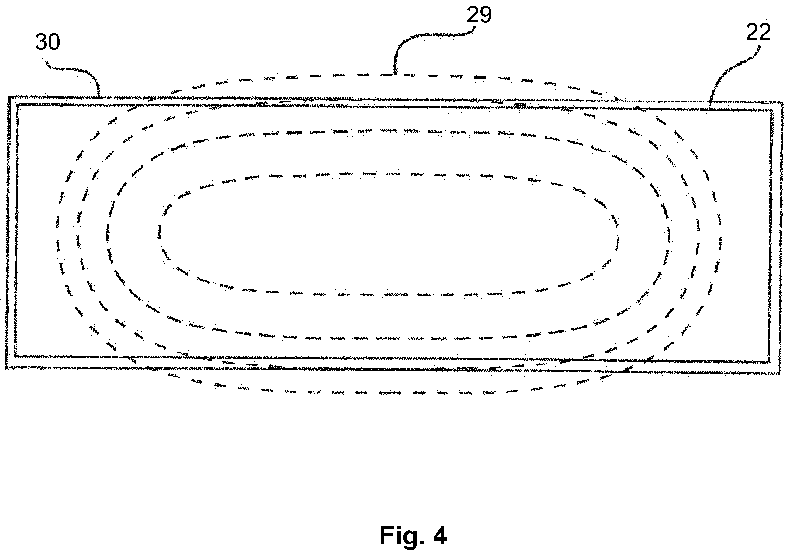

Die Figur 4 - 6 zeigen in schematischer Widergabe die Ergebnisse von Simulationsrechnungen. Dargestellt ist eine Leiterschleife 22, welche die Windung 22 der Nahfeld-Übertragungsspule 21 bildet. Die Leiterschleife 22 ist auf einer Leiterplatte 30 ausgebildet, um bei einer entsprechenden Bestromung ein Magnetfeld aufzubauen. Die gestrichelten Linien 29 zeigen dabei die Verläufe gleicher Magnetfeldstärken.

In Figur 4 ist im Inneren der Leiterschleife 22 kein elektrisch leitfähiges Material auf der Leiterplatte 30 aufgebracht. Entsprechend bildet sich ein Magnetfeld gemäß den Linien 29 aus.

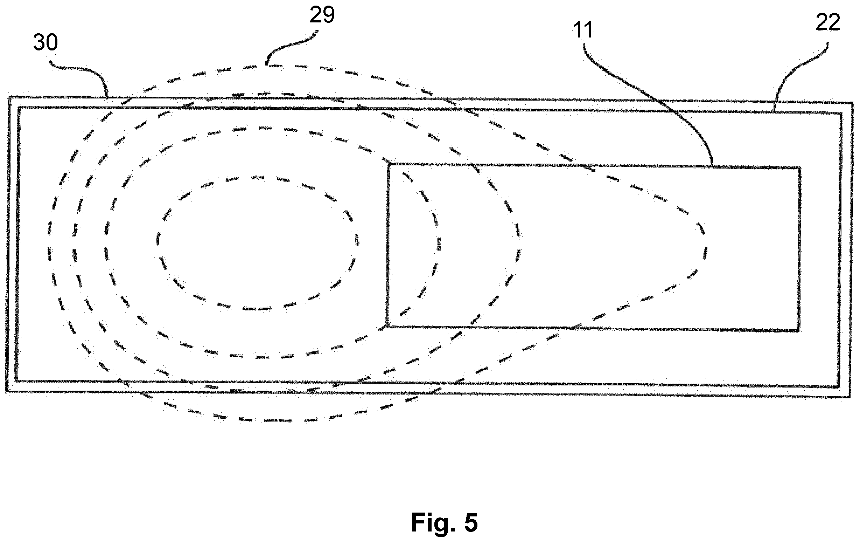

In Figur 5 ist hingegen eine Sensoranordnung gezeigt, bei welcher die Sensorelektrode 11 mit einer Elektrodenfläche als Vollfläche ausgebildet ist. Bei einer solchen Vollfläche 11 wird das Magnetfeld gemäß den Linien 29 erheblich geschwächt und konzentriert sich im Wesentlichen auf den unbelegten freien Bereich innerhalb der Windung 22.

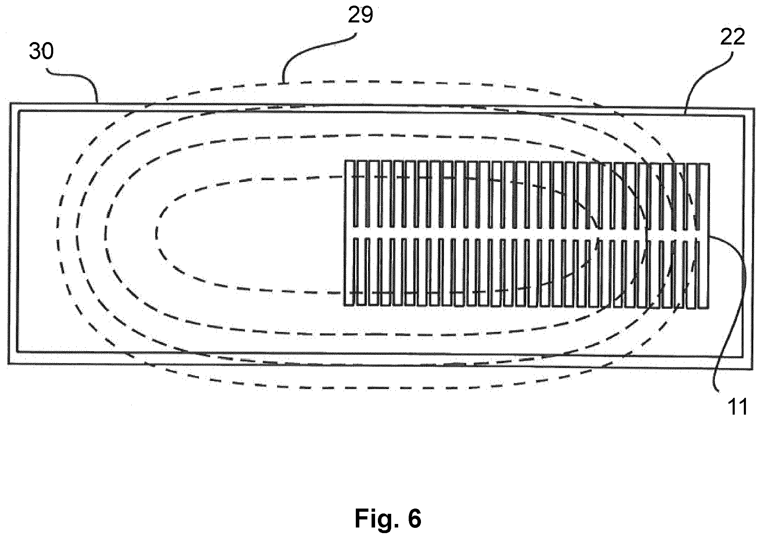

In Figur 6 ist hingegen eine Sensoranordnung 1 gezeigt, bei welcher die Vollfläche 11 durch eine Sensorelektrode 11 mit einem Mittelleiter 11.2 und einer Vielzahl von Abzweigleitern 11.1 ersetzt wurde. Die Abzweigleiter 11.1 weisen jeweils Abstände zueinander auf, die eine Ausbildung von Wirbelströmen großen Durchmessers verhindern. Außerdem kann der Mittelleiter entlang einer Symmetrieachse der Spule 21 angeordnet sein. Hierbei haben die Simulationsrechnungen überraschend ergeben, dass ein erzeugtes Magnetfeld nur geringfügig geschwächt gegenüber dem Magnetfeld aus Figur 4 ohne Sensorelektrode ausgebildet wird. Entsprechend kann sowohl die Kopplung der Windung 22 als auch die Sensorelektrode 11 bei besserer Ausnutzung des Bauraums genutzt werden.

In Figur 6 ist beispielhaft eine Anordnung der Abzweigleiter 11.1 gezeigt, wobei die Breiten der jeweiligen Abzweigleiter größer sind als die Abstände der Abzweigleiter 11.1 voneinander. Dieses Verhältnis von Breiten der Abzweigleiter 11.1 zu dem Abstand der Abzweigleiter 11.1 kann jedoch - wie oben beschrieben - in einem erheblichen Rahmen variiert werden.

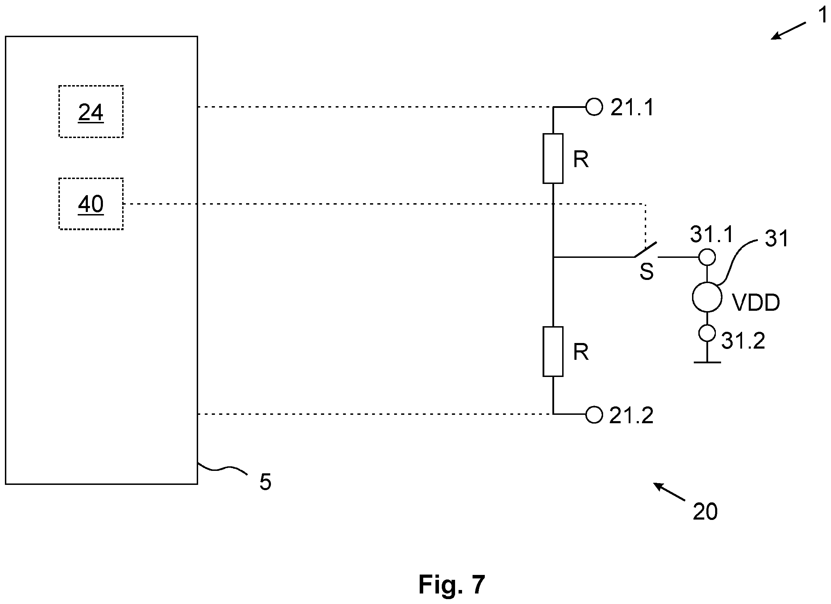

In Figur 7 ist schematisch eine erfindungsgemäße Sensoranordnung 1 für ein Fahrzeug 2 gezeigt, welche eine (in Figur 7 nicht explizit dargestellte) kapazitive Sensorvorrichtung 10 mit wenigstens einer Sensorelektrode 11 zur kapazitiven Erfassung aufweist. Ferner ist eine eine Nahfeld-Übertragungsvorrichtung 20 vorgesehen, welche eine Kontrollelektronik 24 aufweist. Diese Kontrollelektronik 24 ist über einen ersten Anschluss 21.1 und einen zweiten Anschluss 21.2 mit einer Nahfeld-Übertragungsspule 21 verbunden, um eine kontaktlose Übertragung mittels Nahfeldübertragung, vorzugsweise NFC, bereitzustellen. Hierzu weist die Nahfeld-Übertragungsspule 21, wie bereits zuvor beschrieben wurde, wenigstens eine Windung 22 auf, welche benachbart zur Sensorelektrode 11 auf einer Leiterplatte 30 ausgebildet sein kann (siehe hierzu Figur 2). Die Anschlüsse 21.1, 21.2 können z. B. in der Form eines Teils einer Leiterbahn auf der Leiterplatte 30 ausgebildet sein.

In Figur 7 ist ferner gezeigt, dass eine Steuerelektronik 40 zur Umschaltung zwischen einem Erfassungszustand und einem Übertragungszustand mit einem Schaltmittel S verbunden sein kann. Bei einem Schaltmittel S im geöffneten Schaltzustand, wie in Figur 7 dargestellt, liegt eine Übertragungsverschaltung 120 im Übertragungszustand vor. Dann ist eine kontaktlose Übertragung mittels der Nahfeld-Übertragungsspule 21 möglich. Nach einem Umschalten in einen geschlossenen Schaltzustand des Schaltmittels S liegt hingegen eine Erfassungsverschaltung 110 im Erfassungszustand vor. In Figur 7 ist die Steuerelektronik 40 somit dazu ausgebildet, die Nahfeld-Übertragungsspule 21 kooperativ zur Sensorelektrode 11 anzusteuern, um die kapazitive Erfassung zu unterstützen. Hierzu wird durch das Umschalten des Schaltmittels S in den geschlossenen Schaltzustand der erste und zweite Anschluss 21.1, 21.2 der Nahfeld-Übertragungsspule 21 über Widerstände R mit einem einzigen Anschlusspunkt 31.1 einer Spannungsquelle vorzugsweise Betriebsspannungsquelle 31 der Sensoranordnung 1 elektrisch verbunden, um die Anschlüsse 21.1, 21.2 auf ein Potential, insbesondere Betriebspotential VDD zu legen. Ein zweiter Anschlusspunkt 31.2 der Spannungsquelle, insbesondere Betriebsspannungsquelle 31 kann dabei mit einem Massepotential verbunden sein. Ferner kann die Steuerelektronik 40 auch elektrisch mit der kapazitiven Sensorvorrichtung 10 verbunden sein, um die Umschaltung durchzuführen und zu erkennen, wenn der Erfassungszustand vorliegt.

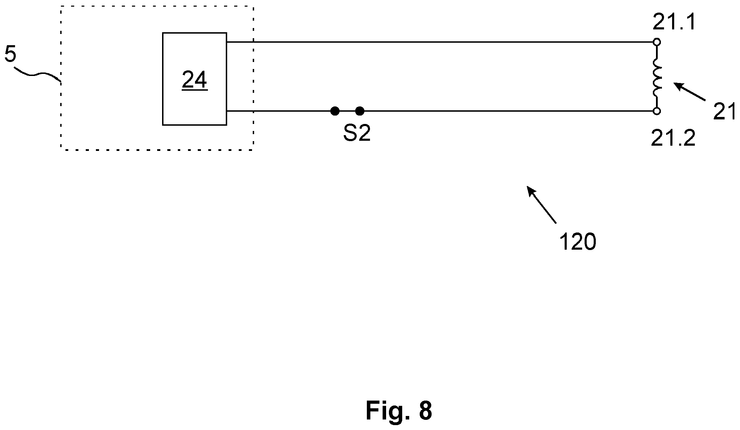

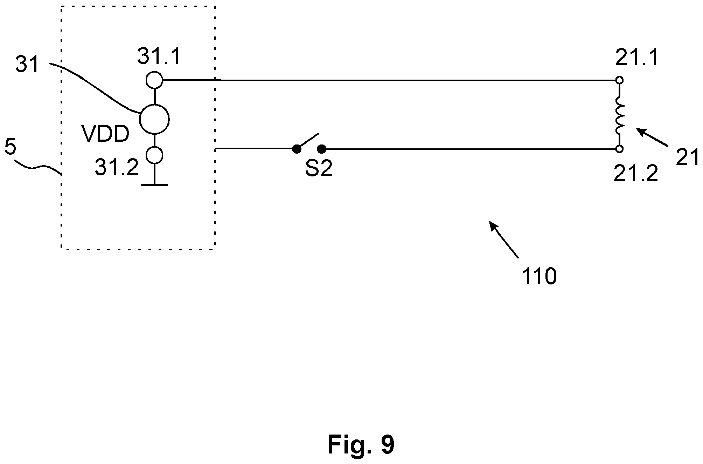

In den Figuren 8 und 9 ist gezeigt, dass die Steuerelektronik 40 auch mit einem unterschiedlich zum Schaltmittel S angeordneten und/oder weiteren Schaltmittel S2 verbunden sein kann, um dieses zur Umschaltung zwischen einer Erfassungsverschaltung 110 und einer Übertragungsverschaltung 120 umzuschalten. In Figur 8 ist die Nahfeld-Übertragungsspule 21 elektrisch über das Schaltmittel S2 (im geschlossenen Schaltzustand) mit einer Sensorelektronik 5 verbunden, um die Nahfeld-Übertragungsspule 21 über die Kontrollelektronik 24 betreiben zu können. Dabei ist die Kontrollelektronik 24 z. B. als NFC-Controller Teil der Sensorelektronik 5.

In Figur 9 ist hingegen das Schaltmittel S2 geöffnet, um die Verbindung der Nahfeld-Übertragungsspule 21 mit der Kontrollelektronik 24 in einem Erfassungszustand zumindest teilweise aufzuheben, und damit die Nahfeld-Übertragungsspule 21 nur noch an ein Potential einer Spannungsquelle 31 anliegt. Zum Aufheben der Verbindung ist ggf. noch ein nicht gezeigter Umschalter vorgesehen. Es wird betont, dass die gezeigte Verschaltung rein schematisch zur Verdeutlichung des Prinzips einer erfindungsgemäßen Sensoranordnung 1 und eines erfindungsgemäßen Verfahrens dient, sodass auch andere Verschaltungen denkbar sind. Ferner kann die Spannungsquelle 31 ebenfalls Teil der Sensorelektronik 5 sein, deren Verschaltung in Figur 9 ebenfalls nicht konkret dargestellt ist. Es ist hierbei möglich, dass der erste Anschluss 21.1 der Nahfeld-Übertragungsspule 21 mit einem einzigen Anschlusspunkt 31.1 der Spannungsquelle 31, insbesondere Gleich- und/oder programmierbare Quelle 31, der Sensoranordnung 1 elektrisch verbunden wird, um den ersten Anschluss 21.1 auf ein Potential VDD zu legen. Weiter kann ein zweiter 21.2 der Anschlüsse 21.1, 21.2 der Nahfeld-Übertragungsspule 21 durch das Schaltmittel S2 geöffnet, also bspw. nur über die Nahfeld-Übertragungsspule 21 mit dem Potential VDD verbunden sein. Alternativ kann auch dieser zweite Anschluss 21.2 zusätzlich mit dem Potential VDD verbunden sein.

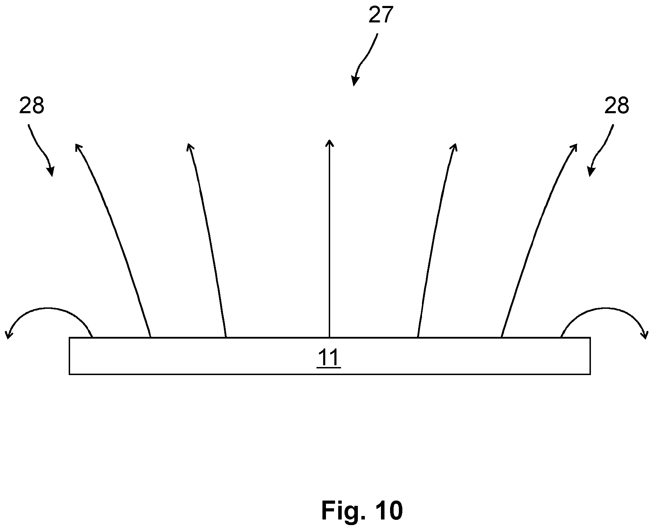

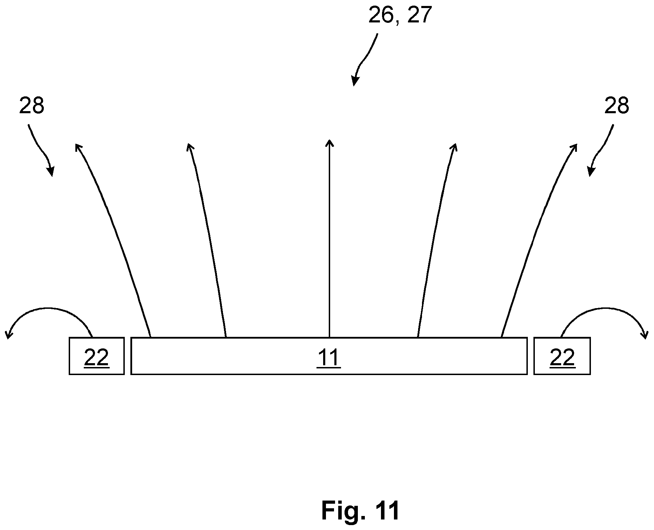

In Figur 10 und 11 ist schematisch ein durch die Sensorelektrode 11 (bzw. in Figur 11 auch durch die Nahfeld-Übertragungsspule 21) und die Windung 22 erzeugtes elektrisches Feld durch Pfeile dargestellt. In Figur 10 wird das gesamte Feld durch die Sensorelektrode 11 bereitgestellt, wobei sich lediglich im mittigen Bereich ein Wirkbereich 27 befindet, in welchem die Erfassung durchgeführt werden soll. In Figur 11 handelt es sich bei dem Wirkbereich 27 je nach Geometrie der Sensoranordnung 1 um den Innenbereich 26, wie bspw. in Figur 2 dargestellt. In Figur 10 wird allerdings die Sensitivität dadurch verringert, dass im Randbereich 28 das elektrische Feld in eine ungewünschte Richtung signifikant abgelenkt wird. Hingegen kann in Figur 11 im Randbereich 28 die Nahfeld-Übertragungsspule 21 kooperativ genutzt werden, um die kapazitive Erfassung der Sensorelektrode 11 zu unterstützen. Hierzu wird auch durch die Nahfeld-Übertragungsspule 21 ein elektrisches Feld bereitgestellt. Dies kann bspw. dadurch bewirkt werden, dass ein zum Potential der Sensorelektrode 11 gleiches oder ähnliches Potential an die Nahfeld-Übertragungsspule 21 und die Windung 22 angelegt wird. Damit kann im Randbereich 28 die Nahfeld-Übertragungsspule 21 das elektrische Feld erzeugen, welches in Figur 10 noch durch die Sensorelektrode 11 bereitgestellt wird. Entsprechend erfolgt die signifikante Ablenkung nunmehr für das elektrische Feld der Nahfeld-Übertragungsspule 21. Dieses dient jedoch nicht zur Erfassung der Annäherung im gewünschten Wirkbereich 27, wird also nicht direkt zur kapazitiven Erfassung genutzt (sondern unterstützt diese). Effektiv erhöht sich auf diese Weise der sensitive Bereich, da ein größerer Anteil des elektrischen Feldes der Sensorelektrode 11 (im Vergleich zum Ausführungsbeispiel gemäß Figur 10) nun für den Wirkbereich 27 genutzt werden kann. Die kapazitive Erfassung und/oder Detektion der Annäherung im Wirkbereich 27 kann dann bspw. durch die kapazitive Sensorvorrichtung 10 dadurch ermöglicht werden, dass eine durch die Sensorelektrode 11 bereitgestellte veränderliche Kapazität erfasst wird. Somit kann festgestellt werden, wenn sich die Kapazität aufgrund einer Annäherung in das elektrische Feld der Sensorelektrode 11 verändert, um die Detektion durchzuführen.

Gemäß Figur 11 kann die Steuerelektronik 40 ausgebildet sein, für die kooperative Ansteuerung ein Potential der Nahfeld-Übertragungsspule 21 in Abhängigkeit von einem Potential der Sensorelektrode 11 festzulegen, vorzugsweise so, dass ein Verhältnis zwischen dem Potential der Nahfeld-Übertragungsspule 21 und dem Potential der Sensorelektrode 11 minimiert wird, um (wie in Figur 11 anhand des elektrischen Felds schematisch dargestellt) eine kapazitive Last bei der kapazitiven Erfassung zu verringern. Gleichzeitig kann hierdurch ein Störeinfluss der Nahfeld-Übertragungsspule 21 auf die kapazitive Erfassung der Sensorelektrode 11 reduziert werden. Die Nahfeld-Übertragungsspule 21 erzeugt dabei über die Windung 22 in dem Randbereich 28 angrenzend zu dem Wirkbereich 27 der Sensorelektrode 11 das elektrische Feld, welches an das von der Sensorelektrode 11 erzeugte elektrische Feld in dem Wirkbereich 27 angeglichen ist, um so die kapazitive Erfassung zu unterstützen.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 1: Sensoranordnung
- 2: Fahrzeug
- 2.1: Fahrzeugtürgriff
- 3: Identifikationsgeber, NFC-Mobilvorrichtung
- 4: Aktivierungsmittel, Hand
- 5: Sensorelektronik

- 10: kapazitive Sensorvorrichtung
- 11: Sensorelektrode
- 11.1: Abzweigleiter
- 11.2: Mittelleiter
- 12: zweite Sensorelektrode

- 20: Nahfeld-Übertragungsvorrichtung
- 21: Nahfeld-Übertragungsspule
- 21.1: erster Anschluss
- 21.2: zweiter Anschluss
- 22: Windung
- 24: Kontrollelektronik, NFC-Controller
- 26: Innenbereich
- 27: Wirkbereich
- 28: Randbereich
- 29: Magnetfeldstärken

- 30: Leiterplatte
- 31: Spannungsquelle, Betriebsspannungsquelle, Gleichspannungsquelle
- 31.1: erster Anschlusspunkt
- 31.2: zweiter Anschlusspunkt
- 40: Steuerelektronik

- 50: Zuleitungen

- 60: Detektionsfeld

- 110: Erfassungsverschaltung

- 120: Übertragungsverschaltung

- VDD: Betriebspotential
- S: Schaltmittel

## Patentansprüche

1. Sensoranordnung (1) für ein Fahrzeug (2), aufweisend
- eine kapazitive Sensorvorrichtung (10), wobei die kapazitive Sensorvorrichtung (10) wenigstens eine Sensorelektrode (11) zur kapazitiven Erfassung aufweist,
- eine Nahfeld-Übertragungsvorrichtung (20), wobei die Nahfeld-Übertragungsvorrichtung (20) wenigstens eine Nahfeld-Übertragungsspule (21) mit zumindest einer Windung (22) benachbart zur Sensorelektrode (11) zur kontaktlosen Übertragung aufweist,
- eine Steuerelektronik (40), welche ausgebildet ist, die Nahfeld-Übertragungsspule (21) kooperativ zur Sensorelektrode (11) anzusteuern, um die kapazitive Erfassung zu unterstützen,
**dadurch gekennzeichnet,**
**dass** die Steuerelektronik (40) ferner dazu ausgebildet ist, für die kooperative Ansteuerung ein Potential der Nahfeld-Übertragungsspule (21) in Abhängigkeit von einem Potential der Sensorelektrode (11) festzulegen, vorzugsweise sodass ein Verhältnis zwischen dem Potential der Nahfeld-Übertragungsspule (21) und dem Potential der Sensorelektrode (11) minimiert wird, um eine kapazitive Last bei der kapazitiven Erfassung zu verringern.

2. Sensoranordnung (1) nach Anspruch 1,
**dadurch gekennzeichnet,**
**dass** die Steuerelektronik (40) ausgebildet ist, für die kooperative Ansteuerung die Nahfeld-Übertragungsspule (21) dann auf ein von einem Massepotential abweichendes Potential zu legen, wenn die kapazitive Sensorvorrichtung (10) in einem Erfassungszustand zur kapazitiven Erfassung aktiviert ist
und/oder dass die Steuerelektronik (40) ausgebildet ist, für die kooperative Ansteuerung die Nahfeld-Übertragungsspule (21) auf ein Potential anzulegen, welches einem Potential entspricht, das an der Sensorelektrode (11) anliegt.

3. Sensoranordnung (1) nach einem der vorhergehenden Ansprüche,
**dadurch gekennzeichnet,**
**dass** die Steuerelektronik (40) ausgebildet ist, die Nahfeld-Übertragungsspule (21) dann kooperativ zur Sensorelektrode (11) anzusteuern, wenn die kapazitive Sensorvorrichtung (10) in einem Erfassungszustand zur kapazitiven Erfassung aktiviert ist, und andernfalls zumindest in einen Übertragungszustand zur kontaktlosen Übertragung umschaltet, sodass abwechselnd die kapazitive Erfassung und die kontaktlose Übertragung erfolgt, vorzugsweise jedoch niemals gleichzeitig
und/oder dass die Steuerelektronik (40) ausgebildet ist, für die kooperative Ansteuerung einen ersten (21.1) der Anschlüsse (21.1, 21.2) der Nahfeld-Übertragungsspule (21) mit einem einzigen Anschlusspunkt (31.1) einer Betriebsspannungsquelle (31) der Sensoranordnung (1) elektrisch zu verbinden, um den ersten Anschluss (21.1) auf ein Betriebspotential (VDD) zu legen, und einen zweiten (21.2) der Anschlüsse (21.1, 21.2) der Nahfeld-Übertragungsspule (21) zu öffnen, wobei vorzugsweise die Betriebsspannungsquelle (31) zur Bereitstellung von 2,5 V oder 5 V als Betriebspotential (VDD) ausgeführt ist.

4. Sensoranordnung (1) nach einem der vorhergehenden Ansprüche,
**dadurch gekennzeichnet,**
**dass** die Steuerelektronik (40) ausgebildet ist, für die kooperative Ansteuerung die Nahfeld-Übertragungsspule (21) in eine Erfassungsverschaltung (110) der Nahfeld-Übertragungsspule (21) zu überführen, sodass ein Störeinfluss der Nahfeld-Übertragungsspule (21) auf die kapazitive Erfassung der Sensorelektrode (11) reduziert wird
und/oder dass die Steuerelektronik (40) ausgebildet ist, für die kooperative Ansteuerung die Nahfeld-Übertragungsspule (21) in eine Erfassungsverschaltung (110) der Nahfeld-Übertragungsspule (21) zu überführen, sodass die Nahfeld-Übertragungsspule (21) in einem Randbereich (28) angrenzend zu einem Wirkbereich (27) der Sensorelektrode (11) ein elektrisches Feld erzeugt, welches an ein von der Sensorelektrode (11) erzeugtes elektrisches Feld in dem Wirkbereich (27) angeglichen ist, um so die kapazitive Erfassung zu unterstützen.

5. Sensoranordnung (1) nach einem der vorhergehenden Ansprüche,
**dadurch gekennzeichnet,**
**dass** eine Erfassungsverschaltung (110) der Nahfeld-Übertragungsspule (21) zur Unterstützung der kapazitiven Erfassung sich von einer Übertragungsverschaltung (120) der Nahfeld-Übertragungsspule (21) zur kontaktlosen Übertragung unterscheidet.

6. Sensoranordnung (1) nach einem der vorhergehenden Ansprüche,
**dadurch gekennzeichnet,**
**dass** die Nahfeld-Übertragungsspule (21) in einem Erfassungszustand zur kapazitiven Erfassung über eine Erfassungsverschaltung (110) mit einer Gleichspannungsquelle (31) verbunden ist
und/oder dass die Nahfeld-Übertragungsspule (21) in einem Erfassungszustand zur kapazitiven Erfassung über eine Erfassungsverschaltung (110) mit einer programmierbaren Quelle verbunden ist, um programmierbar ein Potential für die Nahfeld-Übertragungsspule (21) festzulegen.

7. Sensoranordnung (1) nach einem der vorhergehenden Ansprüche,
**dadurch gekennzeichnet,**
**dass** die Nahfeld-Übertragungsspule (21) in einem Übertragungszustand zur kontaktlosen, vorzugsweise induktiven, Übertragung über eine Übertragungsverschaltung (120) mit einer Kontrollelektronik (24) zur Durchführung der kontaktlosen Übertragung verbunden ist, wobei die Steuerelektronik (40) dazu ausgeführt ist, diese Verbindung mit der Kontrollelektronik (24) in einem Erfassungszustand zumindest teilweise aufzuheben, um eine Erfassungsverschaltung (110) bereitzustellen.

8. Sensoranordnung (1) nach einem der vorhergehenden Ansprüche,
**dadurch gekennzeichnet,**
**dass** die Windung (22), insbesondere schleifenförmig, die Sensorelektrode (11) umgibt, um die kapazitive Erfassung zu unterstützen, vorzugsweise um ein von der Sensorelektrode (11) erzeugtes elektrisches Feld im Erfassungszustand zu unterstützen und/oder abzuschirmen und/oder zu richten.

9. Sensoranordnung (1) nach einem der vorhergehenden Ansprüche,
**dadurch gekennzeichnet,**
**dass** die Nahfeld-Übertragungsspule (21) und die Sensorelektrode (11) derart zueinander auf einer Leiterplatte (30) angeordnet sind, dass die Sensorelektrode (11) in einem von der Windung (22) umgriffenen Innenbereich (26) ausgebildet ist.

10. Sensoranordnung (1) nach einem der vorhergehenden Ansprüche,
**dadurch gekennzeichnet,**
**dass** die Steuerelektronik (40) ausgebildet ist, die Sensorelektrode (11) dann auf ein Massepotenzial zu legen, wenn die Nahfeld-Übertragungsspule (21) in einem Übertragungszustand zur kontaktlosen Übertragung aktiviert ist.

11. Sensoranordnung (1) nach einem der vorhergehenden Ansprüche,
**dadurch gekennzeichnet,**
**dass** die Nahfeld-Übertragungsspule (21) als PCB-Antenne zur Nahfeldkommunikation ausgeführt ist
und/oder dass eine wenigstens einschichtige Leiterplatte (30) vorgesehen ist, auf welcher die wenigstens eine Sensorelektrode (11) und/oder die wenigstens eine Windung (22) ausgebildet sind.

12. Sensoranordnung (1) nach einem der vorhergehenden Ansprüche,
**dadurch gekennzeichnet,**
**dass** die Sensorelektrode (11) einen langgestreckten Mittelleiter (11.2) aufweist und eine Mehrzahl von Abzweigleitern (11.1), die sich von dem Mittelleiter (11.2) erstrecken, wobei die Abzweigleiter (11.1) sich entlang des Mittelleiters (11.2) derart beabstandet voneinander erstrecken, dass die Abzweigleiter (11.1) ausschließlich über den Mittelleiter (11.2) galvanisch gekoppelt sind, wobei die Abzweigleiter (11.1) jeweils paarweise zu voneinander abgewandten Seiten an dem Mittelleiter (11.2) angeordnet sind, so dass zu jedem Abzweigleiter (11.1) ein zugeordneter Abzweigleiter (11.1) auf der jeweils abgewandten Seite des Mittelleiters (11.2) ausgebildet ist
und/oder dass jedes Paar von Abzweigleitern (11.1) bezüglich des Mittelleiters (11.2) symmetrisch ausgebildet ist.

13. Sensoranordnung (1) nach einem der vorhergehenden Ansprüche,
**dadurch gekennzeichnet,**
**dass** sämtliche Abzweigleiter (11.1) gerade ausgebildet sind und in einem einheitlichen Abzweigwinkel zu dem Mittelleiter (11.2) abzweigen.

14. Verfahren zum Betrieb einer Sensoranordnung (1) eines Fahrzeuges (2), wobei die Sensoranordnung (1) nach einem der vorhergehenden Ansprüche ausgestaltet ist, **aufweisend die nachfolgenden Schritte:**
- Ansteuern einer Nahfeld-Übertragungsspule (21) zur kontaktlosen Übertragung, wenn sich die Sensoranordnung (1) in einem Übertragungszustand befindet,
- Ansteuern der Nahfeld-Übertragungsspule (21) zur Unterstützung einer kapazitiven Erfassung einer Sensorelektrode (11), wenn sich die Sensoranordnung (1) in einem Erfassungszustand befindet,
- Umschalten zwischen dem Erfassungszustand und dem Übertragungszustand.

15. Verfahren nach einem der vorhergehenden Ansprüche,
**dadurch gekennzeichnet,**
**dass** die kontaktlose Übertragung zur Datenübertragung von Authentifizierungsinformationen von einem Identifikationsgeber (3) an das Fahrzeug (2) durchgeführt wird, um eine sicherheitsrelevante Funktion am Fahrzeug (2) zu aktivieren, und die kapazitive Erfassung zur Detektion einer Annäherung an das Fahrzeug (2) durchgeführt wird, um bei erfolgreicher Detektion die kontaktlose Übertragung zu aktivieren, vorzugsweise durch das Umschalten von dem Erfassungszustand auf den Übertragungszustand.

## Claims

1. Sensor arrangement (1) for a vehicle (2), comprising
- a capacitive sensor device (10), wherein the capacitive sensor device (10) comprises at least one sensor electrode (11) for capacitive sensing,
- a near-field transfer device (20), the near-field transfer device (20) comprising at least one near-field transfer coil (21) having at least one turn (22) adjacent the sensor electrode (11) for contactless transfer,
- control electronics (40), which is adapted to drive the near-field transfer coil (21) cooperatively with the sensor electrode (11) to support capacitive sensing,
**characterized in that,**
the control electronics (40) are further adapted to determine a potential of the near-field transfer coil (21) for the cooperative control in dependence on a potential of the sensor electrode (11), preferably such that a ratio between the potential of the near-field transfer coil (21) and the potential of the sensor electrode (11) is minimized to reduce a capacitive load in the capacitive detection.

2. Sensor arrangement (1) according to claim 1,
**characterized in that**
the control electronics (40) are designed to connect the near-field transmission coil (21) to a potential other than a ground potential for the cooperative control when the capacitive sensor device (10) is activated in a detection state for capacitive detection
and/or **in that** the control electronics (40) are designed to apply the near-field transmission coil (21) to a potential which corresponds to a potential which is applied to the sensor electrode (11) for the cooperative control.

3. Sensor arrangement (1) according to any one of the preceding claims,
**characterized in that**
the control electronics (40) are designed to drive the near-field transmission coil (21) cooperatively with the sensor electrode (11) when the capacitive sensor device (10) is activated in a detection state for capacitive detection, and otherwise to switch at least to a transmission state for contactless transmission, so that the capacitive detection and the contactless transmission take place alternately, but preferably never simultaneously
and/or **in that** the control electronics (40) are designed to electrically connect a first (21.1) of the terminals (21.1, 21.2) of the near-field transmission coil (21) to a single connection point (31.1) of an operating voltage source (31) of the sensor arrangement (1) for the cooperative control, in order to apply the first terminal (21.1) to an operating potential (VDD), and to open a second (21.2) of the terminals (21.1, 21.2) of the near-field transfer coil (21), wherein preferably the operating voltage source (31) is designed to provide 2.5 V or 5 V as operating potential (VDD).

4. Sensor arrangement (1) according to any one of the preceding claims,
**characterized in that**
the control electronics (40) are designed to transfer the near-field transfer coil (21) into a detection circuit (110) of the near-field transfer coil (21) for the cooperative control, so that an interference influence of the near-field transfer coil (21) on the capacitive detection of the sensor electrode (11) is reduced
and/or **in that** the control electronics (40) are designed to transfer the near-field transfer coil (21) into a detection circuit (110) of the near-field transfer coil (21) for the cooperative activation, so that the near-field transfer coil (21) generates an electric field in an edge region (28) adjacent to an effective region (27) of the sensor electrode (11), which electric field is matched to an electric field generated by the sensor electrode (11) in the effective region (27) in order to support the capacitive detection.

5. Sensor arrangement (1) according to any one of the preceding claims,
**characterized in that**
a detection circuit (110) of the near-field transmission coil (21) for supporting capacitive detection is different from a transmission circuit (120) of the near-field transmission coil (21) for contactless transmission.

6. Sensor arrangement (1) according to any one of the preceding claims,
**characterized in that**
the near-field transmission coil (21) is connected to a DC voltage source (31) in a detection state for capacitive detection via a detection circuit (110) and/or **in that** the near-field transfer coil (21) in a capacitive sensing state is connected to a programmable source via a sensing circuit (110) to programmably set a potential for the near-field transfer coil (21).

7. Sensor arrangement (1) according to any one of the preceding claims,
**characterized in that**
the near-field transmission coil (21) in a transmission state for contactless, preferably inductive, transmission is connected via a transmission circuit (120) to control electronics (24) for carrying out the contactless transmission, the control electronics (40) being designed to at least partially cancel this connection to the control electronics (24) in a detection state in order to provide a detection circuit (110).

8. Sensor arrangement (1) according to any one of the preceding claims,
**characterized in that**
the winding (22) surrounds the sensor electrode (11), in particular in a loop shape, in order to support the capacitive detection, preferably in order to support and/or shield and/or direct an electric field generated by the sensor electrode (11) in the detection state.

9. Sensor arrangement (1) according to any one of the preceding claims,
**characterized in that**
the near-field transmission coil (21) and the sensor electrode (11) are arranged with respect to one another on a printed circuit board (30) in such a way that the sensor electrode (11) is formed in an inner region (26) surrounded by the winding (22).

10. Sensor arrangement (1) according to any one of the preceding claims,
**characterized in that**
the control electronics (40) are designed to connect the sensor electrode (11) to a ground potential when the near-field transmission coil (21) is activated in a transmission state for contactless transmission.

11. Sensor arrangement (1) according to any one of the preceding claims,
**characterized in that**
the near-field transmission coil (21) is designed as a PCB antenna for near-field communication
and/or **in that** an at least single-layer printed circuit board (30) is provided, on which the at least one sensor electrode (11) and/or the at least one winding (22) are formed.

12. Sensor arrangement (1) according to any one of the preceding claims,
**characterized in that**
the sensor electrode (11) comprises an elongated center conductor (11.2) and a plurality of branch conductors (11.1) extending from the center conductor (11.2), the branch conductors (11.1) extending along the center conductor (11.2) spaced apart from each other such that the branch conductors (11.1) are galvanically coupled exclusively via the center conductor (11.2), wherein the branch conductors (11.1) are each arranged in pairs on the center conductor (11.2) on sides facing away from one another, so that an associated branch conductor (11.1) is formed for each branch conductor (11.1) on the side of the center conductor (11.2) facing away from one another in each case
and/or that each pair of branch conductors (11.1) is symmetrical with respect to the center conductor (11.2).

13. Sensor arrangement (1) according to any one of the preceding claims,
**characterized in that**
all branch conductors (11.1) are straight and branch off at a uniform angle to the center conductor (11.2).

14. Method for operating a sensor arrangement (1) of a vehicle (2), wherein the sensor arrangement (1) is configured according to one of the preceding claims,
**comprising the following steps:**
- Controlling a near-field transmission coil (21) for contactless transmission when the sensor arrangement (1) is in a transmission state,
- Controlling the near-field transfer coil (21) to support capacitive sensing of a sensor electrode (11) when the sensor arrangement (1) is in a sensing state,
- Switching between the detection state and the transmission state.

15. The method according to any one of the preceding claims,
**characterized in that**
the contactless transmission for data transmission of authentication information from an identification transmitter (3) to the vehicle (2) is carried out in order to activate a safetyrelevant function on the vehicle (2), and the capacitive detection for detection of an approach to the vehicle (2) is carried out in order to activate the contactless transmission if the detection is successful, preferably by switching from the detection state to the transmission state.

## Revendications

1. Ensemble de capteurs (1) pour un véhicule (2), comprenant
- un dispositif de détection capacitif (10), le dispositif de détection capacitif (10) présentant au moins une électrode de détection (11) pour la détection capacitive,
- un dispositif de transmission en champ proche (20), le dispositif de transmission en champ proche (20) comprenant au moins une bobine de transmission en champ proche (21) ayant au moins une spire (22) adjacente à l'électrode de capteur (11) pour une transmission sans contact,
- une électronique de commande (40), qui est conçue pour commander la bobine de transmission de champ proche (21) de manière coopérative par rapport à l'électrode de capteur (11) afin d'assister la détection capacitive,
**caractérisé en ce que,**
l'électronique de commande (40) est en outre conçue pour fixer, pour la commande coopérative, un potentiel de la bobine de transmission de champ proche (21) en fonction d'un potentiel de l'électrode de capteur (11), de préférence de telle sorte qu'un rapport entre le potentiel de la bobine de transmission de champ proche (21) et le potentiel de l'électrode de capteur (11) soit minimisé afin de réduire une charge capacitive lors de la détection capacitive.

2. Ensemble de capteurs (1) selon la revendication 1,
**caractérisé en ce que**
l'électronique de commande (40) est conçue, pour la commande coopérative, pour mettre la bobine de transmission de champ proche (21) à un potentiel différent d'un potentiel de masse, lorsque le dispositif de détection capacitif (10) est activé dans un état de détection pour la détection capacitive
et/ou **en ce que** l'électronique de commande (40) est conçue pour appliquer, pour la commande coopérative, la bobine de transmission de champ proche (21) à un potentiel qui correspond à un potentiel qui est appliqué à l'électrode de capteur (11).

3. Ensemble de capteurs (1) selon l'une des revendications précédentes,
**caractérisé en ce que**
l'électronique de commande (40) est conçue pour commander la bobine de transmission de champ proche (21) de manière coopérative par rapport à l'électrode de capteur (11) lorsque le dispositif de capteur capacitif (10) est activé dans un état de détection pour la détection capacitive et, dans le cas contraire, commute au moins dans un état de transmission pour la transmission sans contact, de sorte que la détection capacitive et la transmission sans contact s'effectuent en alternance, mais de préférence jamais simultanément
et/ou **en ce que** l'électronique de commande (40) est conçue pour relier électriquement, pour la commande coopérative, un premier (21.1) des raccordements (21.1, 21.2) de la bobine de transmission de champ proche (21) à un seul point de raccordement (31.1) d'une source de tension de service (31) de l'agencement de capteurs (1), afin de mettre le premier raccordement (21.1) à un potentiel de fonctionnement (VDD), et ouvrir une deuxième (21.2) des bornes (21.1, 21.2) de la bobine de transmission de champ proche (21), la source de tension de fonctionnement (31) étant de préférence conçue pour fournir 2,5 V ou 5 V comme potentiel de fonctionnement (VDD).

4. Ensemble de capteurs (1) selon l'une des revendications précédentes,
**caractérisé en ce que**
l'électronique de commande (40) est conçue, pour la commande coopérative, pour transformer la bobine de transmission de champ proche (21) en un circuit de détection (110) de la bobine de transmission de champ proche (21), de sorte qu'une influence perturbatrice de la bobine de transmission de champ proche (21) sur la détection capacitive de l'électrode de capteur (11) est réduite
et/ou **en ce que** l'électronique de commande (40) est conçue, pour la commande coopérative, pour transformer la bobine de transmission de champ proche (21) en un circuit de détection (110) de la bobine de transmission de champ proche (21), de sorte que la bobine de transmission de champ proche (21) génère dans une zone de bordure (28) adjacente à une zone active (27) de l'électrode de détection (11) un champ électrique qui est adapté à un champ électrique généré par l'électrode de détection (11) dans la zone active (27), afin d'aider ainsi à la détection capacitive.

5. Ensemble de capteurs (1) selon l'une des revendications précédentes,
**caractérisé en ce que**
un circuit de détection (110) de la bobine de transmission en champ proche (21) pour assister la détection capacitive diffère d'un circuit de transmission (120) de la bobine de transmission en champ proche (21) pour la transmission sans contact.

6. Ensemble de capteurs (1) selon l'une des revendications précédentes,
**caractérisé en ce que**
la bobine de transmission de champ proche (21) est reliée, dans un état de détection, à une source de tension continue (31) pour la détection capacitive par l'intermédiaire d'un circuit de détection (110)
et/ou **en ce que** la bobine de transmission de champ proche (21) est reliée, dans un état de détection pour la détection capacitive, à une source programmable par l'intermédiaire d'un circuit de détection (110), afin de fixer de manière programmable un potentiel pour la bobine de transmission de champ proche (21).

7. Ensemble de capteurs (1) selon l'une des revendications précédentes,
**caractérisé en ce que**
la bobine de transmission en champ proche (21) est reliée, dans un état de transmission pour une transmission sans contact, de préférence inductive, par l'intermédiaire d'un circuit de transmission (120), à une électronique de contrôle (24) pour réaliser la transmission sans contact, l'électronique de commande (40) étant conçue pour supprimer au moins partiellement cette liaison avec l'électronique de contrôle (24) dans un état de détection, afin de fournir un circuit de détection (110).

8. Ensemble de capteurs (1) selon l'une des revendications précédentes,
**caractérisé en ce que**
la spire (22) entoure, en particulier en forme de boucle, l'électrode de détection (11) pour assister la détection capacitive, de préférence pour assister et/ou protéger et/ou diriger un champ électrique généré par l'électrode de détection (11) dans l'état de détection.

9. Ensemble de capteurs (1) selon l'une des revendications précédentes,
**caractérisé en ce que**
la bobine de transmission de champ proche (21) et l'électrode de capteur (11) sont disposées l'une par rapport à l'autre sur une carte de circuit imprimé (30) de telle sorte que l'électrode de capteur (11) est formée dans une zone intérieure (26) entourée par la spire (22).

10. Ensemble de capteurs (1) selon l'une des revendications précédentes,
**caractérisé en ce que**
l'électronique de commande (40) est conçue pour mettre l'électrode de capteur (11) à un potentiel de masse lorsque la bobine de transmission de champ proche (21) est activée dans un état de transmission pour la transmission sans contact.

11. Ensemble de capteurs (1) selon l'une des revendications précédentes,
**caractérisé en ce que**
la bobine de transmission de champ proche (21) est réalisée sous forme d'antenne PCB pour la communication de champ proche
et/ou **en ce qu'**il est prévu une carte de circuit imprimé (30) au moins monocouche, sur laquelle sont formées la au moins une électrode de capteur (11) et/ou la au moins une spire (22).

12. Ensemble de capteurs (1) selon l'une des revendications précédentes,
**caractérisé en ce que**
l'électrode de capteur (11) présente un conducteur central allongé (11.2) et une pluralité de conducteurs de dérivation (11.1) qui s'étendent à partir du conducteur central (11,2), les conducteurs de dérivation (11.1) s'étendant le long du conducteur central (11.2) à une distance les uns des autres telle que les conducteurs de dérivation (11.1) sont reliés entre eux de manière galvanique par une liaison électrique.1) sont couplés galvaniquement exclusivement par l'intermédiaire du conducteur central (11.2), les conducteurs de dérivation (11.1) étant disposés respectivement par paires sur des côtés opposés les uns aux autres sur le conducteur central (11.2), de sorte que pour chaque conducteur de dérivation (11.1), un conducteur de dérivation (11.1) associé est formé sur le côté respectivement opposé du conducteur central (11.2)
et/ou **en ce que** chaque paire de conducteurs de dérivation (11.1) est réalisée de manière symétrique par rapport au conducteur central (11.2).

13. Ensemble de capteurs (1) selon l'une des revendications précédentes,
**caractérisé en ce que**
tous les conducteurs de dérivation (11.1) sont formés de manière rectiligne et dérivent selon un angle de dérivation uniforme par rapport au conducteur central (11.2).

14. Procédé de fonctionnement d'un ensemble de capteurs (1) d'un véhicule (2), l'ensemble de capteurs (1) étant conçu selon l'une des revendications précédentes,
**comprenant les étapes suivantes** :
- Commander une bobine de transmission en champ proche (21) pour une transmission sans contact lorsque l'ensemble de capteurs (1) se trouve dans un état de transmission,
- Commander la bobine de transmission de champ proche (21) pour assister une détection capacitive d'une électrode de capteur (11) lorsque l'ensemble de capteurs (1) est dans un état de détection,
- Commutation entre l'état de détection et l'état de transmission.

15. Procédé selon l'une quelconque des revendications précédentes,
**caractérisé en ce que**
la transmission sans contact est effectuée pour la transmission de données d'informations d'authentification d'un émetteur d'identification (3) au véhicule (2), afin d'activer une fonction importante pour la sécurité sur le vé(2), et la détection capacitive est effectuée pour la détection d'une approcdu véhicule (2), afin d'activer la transmission sans contact en cas de détection réussie, de préférence par la commutation de l'état de détection à l'état de transmission.
